(19)

Europäisches
Patentamt
European
Patent Office
Office européen
des brevets

(11) **EP 4 101 898 A1**

(12) **EUROPEAN PATENT APPLICATION**
published in accordance with Art. 153(4) EPC

(43) Date of publication:
**14.12.2022 Bulletin 2022/50**

(21) Application number: **21750353.1**

(22) Date of filing: **14.01.2021**

(51) International Patent Classification (IPC):
**C08L 101/00** *(2006.01)*    **H05K 9/00** *(2006.01)*

(52) Cooperative Patent Classification (CPC):
**C08L 101/00; H05K 9/00**

(86) International application number:
**PCT/JP2021/000948**

(87) International publication number:
**WO 2021/157309 (12.08.2021 Gazette 2021/32)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **07.02.2020 JP 2020019713**

(71) Applicant: **NITTO DENKO CORPORATION
Ibaraki-shi
Osaka 567-8680 (JP)**

(72) Inventors:
• **MATSUZAKI Yuya
Ibaraki-shi, Osaka 567-8680 (JP)**
• **FUKE Kazuhiro
Ibaraki-shi, Osaka 567-8680 (JP)**
• **UI Takehiro
Ibaraki-shi, Osaka 567-8680 (JP)**

(74) Representative: **Grünecker Patent- und
Rechtsanwälte
PartG mbB
Leopoldstraße 4
80802 München (DE)**

(54) **COMPOSITE MATERIAL AND ELECTROMAGNETIC WAVE ABSORBER MOLDED FROM SAME**

(57)    A composite material and an electromagnetic wave absorber made by molding the same, which are capable of exhibiting an excellent electromagnetic wave absorption function and capable of suppressing the deterioration of mechanical properties of the electromagnetic wave absorber itself. A composite material comprising a single type of thermoplastic resin and a conductive filler contained in a dispersed state in the thermoplastic resin, wherein the composite material includes at least one portion A and a portion B with different conductive filler content percentages in a mixed manner, and wherein the ratio of the conductive filler content percentage in the portion A to the conductive filler content percentage in the portion B is greater than 1.0; and an electromagnetic wave absorber made by molding the same.

FIG.1

EP 4 101 898 A1

**Description**

TECHNICAL FIELD

The present disclosure relates to a composite material used for an electromagnetic wave absorber for preventing electromagnetic interference, and an electromagnetic wave absorber made by molding the same.

BACKGROUND ART

In recent years, information detection means that use electromagnetic waves (especially millimeter waves) as an information communication medium have been investigated in the fields of motor vehicles, home appliances, life sciences, and the like. As an example, there are collision avoidance systems in the field of motor vehicle technology. The collision avoidance systems automatically apply brakes upon sensing obstacles by means of radar using radio waves in a frequency range of 28 to 81 GHz, and measure the speed of a neighboring vehicle and a distance between a user's vehicle and the neighboring vehicle to control the speed of the user's vehicle and the distance between the vehicles. For normal operation of the collision avoidance systems and the like, it is important to receive as little unwanted electromagnetic wave radiation (noise) as possible in order to prevent false recognition. For this reason, a variety of electromagnetic wave absorbers capable of absorbing and eliminating unwanted electromagnetic wave radiation have been proposed.

For example, PTL 1 discloses an electromagnetic wave absorber comprising a resin composition in which a conductive filler is dispersed in a resin (B) and isolatedly dispersed in a resin (A) that is incompatible with this resin (B). This electromagnetic wave absorber is said to be able to efficiently form a conductive network with a small amount of conductive filler by deliberately making the conductive filler unevenly distributed in the resin (B).

Unfortunately, the electromagnetic wave absorber disclosed in PTL 1 uses at least two types of resins that are incompatible with each other to present a problem such that the mechanical properties of the electromagnetic wave absorber itself are degraded based on differences in properties of the resins from each other.

On the other hand, it has been known that excellent electromagnetic wave absorption performance is obtained by increasing the amount of conductive filler contained in a resin material. In this case, however, there is apprehension not only that the original physical properties of the base resin are changed but also that the mechanical properties of the resulting electromagnetic wave absorber itself are degraded.

RELATED ART DOCUMENT

PATENT DOCUMENT

PTL 1: JP-A-2017-179315

SUMMARY

In view of the foregoing, it is therefore an object of the present disclosure to provide a composite material and an electromagnetic wave absorber made by molding the same, which are capable of exhibiting an excellent absorption function without unnecessarily increasing the amount of conductive filler added, and capable of suppressing the deterioration of mechanical properties of the electromagnetic wave absorber itself, and which are excellent in permanence and reliability of the electromagnetic wave absorption function.

To accomplish the aforementioned object, the present disclosure provides the following [1] to [4] .

[1] A composite material comprising: a single type of thermoplastic resin; and a conductive filler contained in a dispersed state in the thermoplastic resin, wherein the composite material includes a portion A and a portion B each comprising a different content amount of the conductive filler in a mixed manner, and wherein a ratio of the content amount of conductive filler in the portion A to the content amount of conductive filler in the portion B is greater than 1.0.
[2] The composite material according to [1], wherein an area ratio of the portion A per unit area of a cross-section of a molded article made by molding the composite material is 0.1 to 50%.
[3] The composite material according to [1] or [2] comprising a plurality of the portions A recognized in the form of islands in a cross-section of a molded article made by molding the composite material, wherein the number of the portions A found in the entire field of view of 960 pixels in height and 1280 pixels in width is 5 to 2000 when the magnification of a scanning electron microscope is 50 times.
[4] An electromagnetic wave absorber made by molding a composite material according to in any one of [1] to [3].

The present inventors have diligently made studies to solve the aforementioned problem. As a result, the present inventors have found the use of a single (a single type of) thermoplastic resin, rather than the use of multiple types of resins incompatible with each other as in the conventional techniques, for the purpose of creating the first portion (the portion A) and the second portion (the portion B) with different conductive filler content percentages. In addition, the present inventors have found that, by controlling the dispersion state of the conductive filler contained in the thermoplastic resin and setting the ratio of the conductive filler content percentage in the portion A to the conductive filler content percentage in the portion B to greater than 1.0, the deterioration of mechanical properties is suppressed, whereby the electromagnetic wave absorption function is sufficiently exhibited.

According to the present disclosure, a single (a single type of) thermoplastic resin is used as the resin, and the portions A and B with different conductive filler content percentages are generated. The ratio of the conductive filler content percentage in the portion A to the conductive filler content percentage in the portion B is set to greater than 1.0. Thus, the sufficient electromagnetic wave absorption function is exhibited. Also, the use of the single type of thermoplastic resin provides superior durability without impairing the mechanical properties of the electromagnetic wave absorber made by molding the same. In addition, the electromagnetic wave absorber made by molding the composite material of the present disclosure is molded integrally. This prevents the conductive filler from dropping off to achieve excellent permanence and reliability of the electromagnetic wave absorption capacity.

It is generally known that increasing the conductive filler content improves the electromagnetic wave absorption capacity, but increasing the conductive filler content causes a problem such that mechanical properties deteriorate. The present disclosure does not increase the electromagnetic wave absorption capacity by increasing the conductive filler content. The composite material and the electromagnetic wave absorber made by molding the same are superior in this respect as well.

BRIEF DESCRIPTION OF DRAWINGS

[FIG. 1] FIG. 1 shows an image obtained by photographing a cross-section of a molded article made of a composite material with a scanning electron microscope (SEM) according to one embodiment of the present disclosure.

[FIG. 2] FIG. 2 shows an image obtained by binarizing the SEM image of FIG. 1.

[FIG. 3] FIG. 3 shows an enlarged SEM image of a portion A with a high conductive filler content percentage in the cross-section of the molded article.

[FIG. 4] FIG. 4 shows an enlarged SEM image of a portion B with a low conductive filler content percentage in the cross-section of the molded article.

[FIG. 5] FIG. 5 shows an image obtained by binarizing a SEM image of part of the portion A observed at a high magnification.

[FIG. 6] FIG. 6 shows an image obtained by binarizing a SEM image of part of the portion B observed at a high magnification.

[FIG. 7] FIG. 7A shows an image obtained by photographing a cross-section of Example 1 with a SEM; and FIG. 7B shows an image obtained by binarizing the image of FIG. 7A.

[FIG. 8] FIG. 8A shows an image obtained by photographing a cross-section of Example 2 with a SEM; and FIG. 8B shows an image obtained by binarizing the image of FIG. 8A.

[FIG. 9] FIG. 9A shows an image obtained by photographing a cross-section of Example 3 with a SEM; and FIG. 9B shows an image obtained by binarizing the image of FIG. 9A.

[FIG. 10] FIG. 10A shows a SEM image of the portion A of FIG. 7A observed at a high magnification; and FIG. 10B shows an image obtained by binarizing the SEM image of FIG. 10A.

[FIG. 11] FIG. 11A shows a SEM image of the portion B of FIG. 7A observed at a high magnification; and FIG. 11B shows an image obtained by binarizing the SEM image of FIG. 11A.

[FIG. 12] FIG. 12A shows a SEM image of the portion A of FIG. 8A observed at a high magnification; and FIG. 12B shows an image obtained by binarizing the SEM image of FIG. 12A.

[FIG. 13] FIG. 13A shows a SEM image of the portion B of FIG. 8A observed at a high magnification; and FIG. 13B shows an image obtained by binarizing the SEM image of FIG. 13A.

[FIG. 14] FIG. 14A shows a SEM image of the portion A of FIG. 9A observed at a high magnification; and FIG. 14B shows an image obtained by binarizing the SEM image of FIG. 14A.

[FIG. 15] FIG. 15A shows a SEM image of the portion B of FIG. 9A observed at a high magnification; and FIG. 15B shows an image obtained by binarizing the SEM image of FIG. 15A.

DESCRIPTION OF EMBODIMENTS

In describing the present disclosure, specific examples will be given. However, the present disclosure is not limited to the following description without departing from the spirit and scope of the present disclosure, and may be implemented with appropriate changes.

<Composite Material>

A composite material according to one aspect of the present disclosure contains a thermoplastic resin and a conductive filler. The composite material includes at least one portion A and a portion B with different conductive filler content percentages in a mixed manner, and is characterized in that the ratio of the conductive filler content percentage in the portion A to the conductive filler content percentage in the portion B is greater than 1.0.

Details on the "thermoplastic resin", the "conductive filler", and the like related to the "composite material" will be described hereinafter.

The thermoplastic resin used for the composite material is not particularly limited. Examples of the thermoplastic resin used for the composite material include polyethylene, polypropylene, polyvinyl alcohol, polyethylene terephthalate, polybutylene terephthalate, ethylene-vinyl acetate copolymer resin, polystyrene, acrylonitrile-styrene resin, acrylonitrile butadiene styrene copolymer resin, ASA resin, AES resin, acrylic resin such as PMMA, MS resin, MBS resin, cycloolefin resin, polyacetal resin, polyamide resin, polyester resin, polycarbonate resin, polyurethane resin, liquid crystal polymer, PPS, PEEK, PPE, polysulfone resin, polyimide resin, fluororesin, and thermoplastic elastomer. Among these, polypropylene and polyethylene are preferably used.

Based the structure of copolymerization of comonomers, the aforementioned polypropylene is classified into three types: homopolymer, random copolymer, and block copolymer. Among these, polypropylene classified as homopolymer is preferably used because it is easy to set the conductive filler content percentages in the portions A and B to a desired range. For the same reason, an example of the aforementioned polyethylene preferably used herein includes that with a high degree of crystallinity. In particular, the polyethylene with a degree of crystallinity of not less than 30% is more preferable, and the polyethylene with a degree of crystallinity of not less than 40% is further preferable.

The melt flow rate (MFR) of the thermoplastic resin used for the composite material is, for example, preferably in the range of 0.1 to 80 g/10 min, more preferably in the range of 0.2 to 30 g/10 min, and further preferably in the range of 0.3 to 20 g/10 min. When the MFR of the thermoplastic resin is within the aforementioned range, it tends to be easier to set the conductive filler content percentages in the portions A and B to a desired range.

One of the features of the present disclosure is that the thermoplastic resin is used alone (one type) and multiple types of thermoplastic resins are not used together (different types of thermoplastic resins are not allowed to coexist). Specifically, incompatible resins can be mixed together after only one of the incompatible resins is caused to contain the conductive filler for the purpose of creating a difference in conductive filler content percentage, for example. This, however, causes the resins with different properties to be contained partially to result in impairment of the mechanical properties of an electromagnetic wave absorber made by molding. For this reason, the present disclosure eliminates such a product to provide a product excellent in durability and mechanical properties.

The conductive filler used for the composite material is not particularly limited. Examples of the conductive filler used for the composite material include metal particles, metal oxide particles, carbon particles, particles made of conductive polymers, and metal-coated particles. Among these, carbon particles, which are lightweight and easy to handle, are preferably used. These particles may be used alone or in combination with multiple types.

The shape of the conductive filler is not particularly limited. For example, the conductive filler may be spherical, rod-shaped, flat, fibrous, hollow, flaky, massive, or agglomeration thereof. Among these, spherical particles that have been primarily agglomerated are preferably used from the viewpoint of easy control of the conductive filler content percentage in the composite material.

Examples of the aforementioned metal particles include particles made of copper, aluminum, nickel, iron, silver, gold, stainless steel, and alloys thereof. Examples of the aforementioned metal oxide particles include particles made of zinc oxide, indium oxide, tin oxide, titanium oxide, and zirconium oxide.

Examples of the aforementioned carbon particles include carbon black, acetylene black, Ketjen black, graphite, carbon nanofibers, carbon nanotubes, graphene, fullerene, carbon nanocoils, carbon microcoils, carbon beads, and carbon fibers. Among these, carbon black is preferably used because of its low costs and easy availability.

The aforementioned carbon black is not particularly limited. However, carbon blacks with a particle size of not greater than 50 nm, with a specific surface area of not less than 50 $m^2$/100 g, and with a DBP absorption number of not less than 100 $cm^3$/100 g are preferably used. Examples of such carbon blacks include TOKABLACK #5500, #4500, and Seast 116HM (available from Tokai Carbon Co., Ltd.), #2600 and #3400B (available from Mitsubishi Chemical Corporation), VULCAN P and VULCAN XC72 (available from Cabot Corporation), and Asahi AX-015, Asahi #200-GS, and Asahi #60HN (available from Asahi Carbon Co., Ltd.).

The aforementioned carbon black is not particularly limited. However, carbon black subjected to no surface treatment is preferably used. If surface-treated carbon black is used, it is preferable that a large amount of material that becomes volatile components such as carboxy groups is not imparted to the surface. For example, the weight of the material imparted by the surface treatment is preferably not greater than 15% by weight of the carbon black, and more preferably not greater than 3% by weight of the carbon black.

The aforementioned carbon black is not particularly limited. However, carbon black in which multiple particles are bonded and connected to each other is preferably used. In particular, carbon black in which the multiple particles are in the range of 0.02 to 1 $\mu$m in size (structure) is more preferably used, and carbon black in which the multiple particles are in the range of 0.03 to 0.5 $\mu$m in size (structure) is further preferably used.

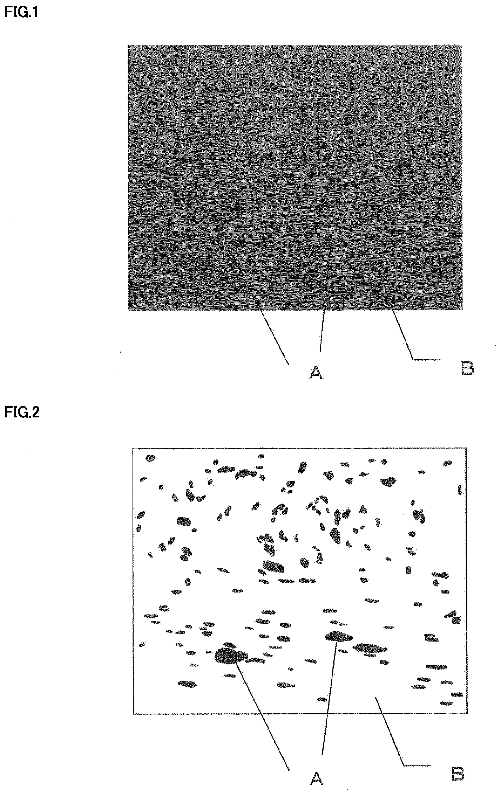

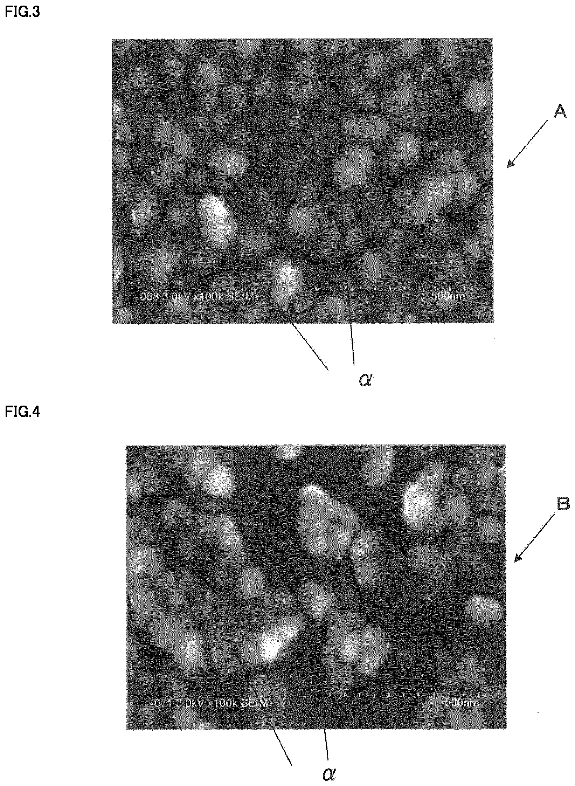

The composite material of the present disclosure includes the portions A and B with different conductive filler content percentages in a mixed manner. Discrimination between the portions A and B is made, for example, in a manner to be described below. First, the composite material is molded into a plate shape to produce a plate-like molded article (test specimen). A precision high-speed cutting machine or the like is used to cut the test specimen in the vicinity of the middle thereof as seen in a flow direction (or a line that passes through the center thereof as seen in plan view and divides the area thereof into two if there is no flow direction). A sample pre-treatment device such as an ion milling device is used to polish, coat, or otherwise treat a cross-section of the test specimen, thereby facilitating the observation of the cross-section of the test specimen with a SEM. The cross-section of the test specimen subjected to this treatment is observed and photographed with a SEM of a magnification of 50 times (with reference to FIG. 1). In the aforementioned photographed image (SEM image), a white portion recognized as being island-like (a portion densely containing the conductive filler) is designated as the portion A, and the other black portion recognized as being sealike (a portion coarsely containing the conductive filler) is designated as the portion B (the same holds for the following figures). Part of the portion A which is observed partially at a magnification of 100000 times is shown in FIG. 3, and part of the portion B which is observed partially at a magnification of 100000 times is shown in FIG. 4. In FIGS. 3 and 4, the reference character $\alpha$ designates the conductive filler, and it is found that the portion A (FIG. 3) contains the conductive filler $\alpha$ more densely, that is, with a higher content percentage than the portion B (FIG. 4).

The aforementioned SEM image may be observed using a secondary electron image under conditions of a work distance of 8 mm and an irradiation power of 3 kV by means of a device known as S-4800 (available from Hitachi, Ltd.). Also, the discrimination between the portions A and B can be made visually from the aforementioned photographed image, but is easily made by binarizing the image based on color tones by means of image analysis software (e.g., "ImageJ") (with reference to FIG. 2). In addition, if the portion A is not found when the cross-section of the test specimen is observed with the SEM of a magnification of 50 times, a 3 mm × 3 mm square area in the cross-section is observed, and a location where the portion A is found is selected.

The aforementioned binarization is performed in a manner to be described below.

Specifically, a SEM image photographed at a magnification of 50 times so that the cross-section of the test specimen occupies the entire SEM screen is imported into the aforementioned ImageJ to prepare an analysis image. The analysis image is converted to a gray-scale image, and brightness values are adjusted so as to make the outline of the island-like portion A clear, whereby the binarization is performed in a manner similar to the binarization of FIG. 2.

If the binarization cannot be performed in the aforementioned procedure, for example, because the contrast between the portions A and B does not clearly appear in the SEM image at a magnification of 50 times or because components other than the conductive filler are recognized as the conductive filler, the portion A is identified by the following preprocessing. In the aforementioned SEM image, only locations where the conductive filler is agglomerated are colored black, and the other locations are colored white. After this process, the image is binarized by importing the image into the aforementioned ImageJ.

On the other hand, the binarization of a SEM image with a magnification of 20000 times to be described below is performed using the same procedure as the binarization of the SEM image with a magnification of 50 times. In this binarization, the threshold value of the brightness value to be represented in 256 steps from 0 to 255 is set to 151. For a device in which the threshold value is not represented in 256 steps, a threshold value similar to that described above may be used.

In the aforementioned SEM image with a magnification of 50 times or a binarized image thereof, the at least one portion A typically includes a plurality of portions A appearing in the form of islands. The area occupied by the portions A in the aforementioned SEM image is preferably 0.1 to 50%, more preferably 0.5 to 30%, and further preferably 1 to 20%. In other words, the composite material of the present disclosure tends to have an excellent balance between electromagnetic wave absorption capacity and mechanical properties when the area percentage of the portions A per unit area of the cross-section of the molded article made by molding the composite material is within the aforementioned range.

The area of each of the islands of the portions A is preferably 1 to 100000 $\mu$m$^2$, more preferably 2 to 50000 $\mu$m$^2$, and further preferably 3 to 30000 $\mu$m$^2$ in terms of an excellent balance between electromagnetic wave absorption performance and mechanical properties. The average of the areas of the islands is obtained by dividing the sum of the areas of the islands of the portions A recognized in the binary image of the SEM image with a magnification of 50 times by the number of islands. For purposes of eliminating measurement errors, islands of the portions A each having an area of less than 3 $\mu$m$^2$ and those each having an area of greater than 30000 $\mu$m$^2$ are eliminated. These are typically calculated by the use of the aforementioned image analysis software.

In the aforementioned SEM image and the binarized image thereof, the number of portions A can be counted because the portions A typically appear in the form of islands. The number of portions A is preferably not less than 5, more preferably not less than 100, further preferably not less than 1000, and still further preferably not less than 2000.

If the number of portions A is too small, transmission attenuation tends to decrease due to decreased conductivity. If the number of portions A is too large, return loss tends to decrease due to too high conductivity. The shape of the islands of the portions A is various, such as circular, oval, polygonal, and indefinite. The number of portions A may be typically calculated using the aforementioned binarized image by means of the aforementioned image analysis software.

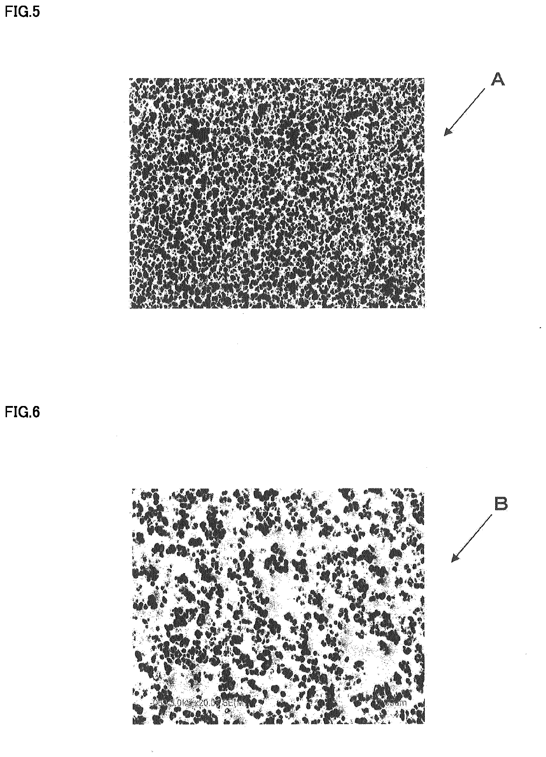

The conductive filler content percentages in the portions A and B are calculated, for example, in a manner to be described below. In portions recognized as the portions A or the portion B in the photographed image, arbitrary locations (e.g., three to five locations) are selected, and the selected locations are observed and photographed at a magnification of 20000 times. This allows the kneading state of the thermoplastic resin and the conductive filler which cannot be recognized at a magnification of 50 times to be seen in detail. When the photographed images are binarized, images in which white and black are mixed are obtained as shown in FIG. 5 (the portions A) and FIG. 6 (the portion B). In the aforementioned binarized images, the color tones of locations typically shown in white and locations shown in black in the SEM images are inverted for purposes of calculating the conductive filler content percentages more accurately. In each of the images, the percentage of the area of a location where the conductive filler is recognized (locations shown in black in FIGS. 5 and 6) with respect to the area of the entire binary image is calculated. This percentage is defined as the conductive filler content percentage in each of the portions. These values are also typically calculated by means of the aforementioned image analysis software.

The conductive filler content percentage (% by area) in the portions A is set, for example, in the range of 30 to 80% by area of the aforementioned entire image with a magnification of 20000 times, preferably in the range of 40 to 70% by area, and more preferably in the range of 50 to 65% by area. The conductive filler content percentage (% by area) in the portion B is set, for example, in the range of 5 to 70% by area of the aforementioned entire image with a magnification of 20000 times, preferably in the range of 10 to 60% by area, and more preferably in the range of 15 to 50% by area. One of the features of the present disclosure is that the portion B, which is low in conductive filler content percentage, also contains at least a fixed amount of conductive filler, although the conductive filler content percentage in the portions A is higher than the conductive filler content percentage in the portion B.

The conductive filler content percentage in the portions A relative to the conductive filler content percentage (% by area) in the portion B is calculated by calculating the conductive filler content percentages in three to five arbitrary locations in the portions A and B, adopting the minimum value among the obtained values in the portions A, and adopting the maximum value among the obtained values in the portion B.

The composite material of the present disclosure has a value β calculated by Equation (1) below preferably in the range of 0.1 to 500, more preferably in the range of 0.2 to 300, and further preferably in the range of 0.3 to 200.

$$C \times D \times E = \beta \qquad\qquad (1)$$

where C is the conductive filler content percentage (% by area) in the portion B, D is the area percentage (% by area) of the portions A per unit area of the cross-section of the molded article made by molding the composite material, and E is the average ($\mu$m$^2$) of the areas of the islands of the portions A. In other words, the number of islands of the portion A may be small when the area of each island is large; conversely, the number of islands of the portion A tends to be preferably large when the area of each island is small.

According to the aforementioned configuration, the composite material includes the portions A and B with different conductive filler content percentages in a mixed manner, and the ratio of the conductive filler content percentage in the portions A to the conductive filler content percentage in the portion B is greater than 1.0. This allows the manufacture of an electromagnetic wave absorber having a superior electromagnetic wave absorption function, as compared with a composite material in which a conductive filler is uniformly dispersed in a resin. Also, the use of a single type (one type) of thermoplastic resin provides homogeneous mechanical properties of the entire electromagnetic wave absorber made by molding the same. This prevents partial breakage based on uneven mechanical properties to achieve superior durability. In addition, the electromagnetic wave absorber made by molding the aforementioned composite material is molded integrally. This prevents the conductive filler from dropping out of the thermoplastic resin to achieve excellent permanence and reliability of the electromagnetic wave absorption capacity.

Such a composite material is obtained, for example, by selecting a combination of the thermoplastic resin and the conductive filler, blending the thermoplastic resin and the conductive filler simultaneously, and controlling the mixing. Such a composite material is also obtained by preparing a plurality of single (one type) thermoplastic resins with different conductive filler content percentages by varying the amount of conductive filler added to the thermoplastic resins, and mixing the thermoplastic resins simultaneously or sequentially in a controlled manner.

Particularly preferred combinations for the composite material of the present disclosure include a combination of polypropylene and polyethylene used as the thermoplastic resin and carbon black used as the conductive filler, a combination of polypropylene and polyethylene used as the thermoplastic resin and carbon fibers used as the conductive filler, or a combination of polypropylene and polyethylene used as the thermoplastic resin and carbon nanotubes used as the conductive filler.

Then, the dispersion state of the conductive filler in the thermoplastic resin is observed, and the mixing conditions (e.g., temperature and shear force) of the thermoplastic resin and the conductive filler are controlled. Examples of the mixing method include: a method of kneading in predetermined proportions in a single-screw or multi-screw kneading machine, a batch-type mixer such as Labo Plastomill, a roll kneading machine, or the like; and a method of mixing in a dissolved or suspended state using a solvent. However, a method of mixing in a kneading machine or a batch-type mixer is especially preferred in terms of productivity.

It is only necessary that the aforementioned mixing temperature (kneading temperature) is a temperature at which the thermoplastic resin and the conductive filler can be mixed (kneaded). The aforementioned mixing temperature (kneading temperature) is preferably higher than the melting point of the thermoplastic resin, more preferably not less than 20°C higher than the melting point of the thermoplastic resin, further preferably not less than 40°C higher than the melting point of the thermoplastic resin, and still further preferably not less than 60°C higher than the melting point of the thermoplastic resin.

It is only necessary that the revolution speed in the aforementioned kneading is a speed at which the thermoplastic resin and the conductive filler can be mixed (kneaded). However, it is preferred that the revolution speed is as low as possible. For example, the revolution speed is preferably not greater than 70 rpm, more preferably not greater than 50 rpm, and further preferably not greater than 20 rpm. The kneading time is not particularly limited. However, for example, the kneading time is preferably 2 to 10 minutes, more preferably 3 to 7 minutes, and further preferably 4 to 6 minutes.

To obtain a preferable conductive filler dispersion state in the aforementioned mixing method, it is preferable that 3 to 30% by volume of the conductive filler is contained in the total volume of the composite material, and it is more preferable that 5 to 20% by volume of the conductive filler is contained.

The composite material of the present disclosure may contain additives other than the thermoplastic resin and the conductive filler to the extent of not impairing the object of the present disclosure. Examples of such additives include flame retardants, impact resistance improving agents, reinforcing agents, compatibilizers, weather resistance improving agents, antioxidants, pigments, and dyes.

<Electromagnetic Wave Absorber>

The composite material of the present disclosure is formed by pressing, injection molding, extrusion, compression molding, blow molding, or the like, and may be made into, for example, an electromagnetic wave absorber in plate, sheet, or other three-dimensional shapes.

The electromagnetic wave absorber of the present disclosure has a thickness, for example, preferably in the range of 0.5 to 10 mm, more preferably in the range of 1 to 5 mm, and further preferably in the range of 2 to 4 mm. If the thickness is too small, the strength of the electromagnetic wave absorber tends to be insufficient. If the thickness is too large, the weight of the electromagnetic wave absorber tends to be too heavy.

The electromagnetic wave absorber of the present disclosure typically has a transmission attenuation and a return loss both in the range of 3 to 75 dB. The electromagnetic wave absorber of the present disclosure has an excellent balance between the transmission attenuation and the return loss. Thus, the transmission attenuation and the return loss are preferably in the range of 4 to 50 dB, and more preferably in the range of 5 to 30 dB.

Furthermore, the transmission attenuation per conductive filler [(transmission attenuation (dB)/conductive filler content (% by volume)] in the electromagnetic wave absorber of the present disclosure is preferably in the range of 0.6 to 15, more preferably in the range of 0.7 to 12, and further preferably in the range of 0.8 to 10.

EXAMPLES

Although the present disclosure will be described hereinafter in further detail using examples, the examples may be modified as appropriate without departing from the spirit and scope of the present disclosure. Therefore, the scope of the present disclosure should not be interpreted as limited by the specific examples illustrated below.

[Example 1]

Using polypropylene (Novatec EA9HD available from Japan Polypropylene Corporation) as a thermoplastic resin and carbon black (TOKABLACK #5500 available from Tokai Carbon Co., Ltd.) as a conductive filler, amounts shown in TABLE 1 below were simultaneously fed using an external feeder through a full feed port at 3 kg/h for polypropylene and at 0.5 kg/h for carbon black. Then, LABO PLASTOMILL (registered trademark) (100C100 available from Toyo Seiki Seisaku-sho, Ltd.) and a twin-screw segment extruder (2D30W2 available from Toyo Seiki Seisaku-sho, Ltd.) were used to melt and knead the polypropylene and the carbon black under conditions shown in TABLE 1 below. Extruded strands were processed into pellets, whereby an intended composite material was obtained.

The carbon black content (% by volume) shown in TABLE 1 is expressed in units of percent by volume with respect to the total volume of the composite material. In the kneading process, kneading twice (twice kneading: a composite material once processed into pellets by the aforementioned method is once again fed through the twin-screw extruder feed port and processed into pellets under the same conditions) provides thermal history and shear energy approximately twice those of the composite material kneaded once.

An air press machine (FCP-500 available from Fuji Controls, Inc.) was used to press the resulting composite material under conditions of a hot plate temperature of 220°C and a pressing time of 3 minutes, thereby obtaining a plate-like electromagnetic wave absorber with a thickness of 3 mm.

[Example 2]

An electromagnetic wave absorber was obtained in the same manner as in Example 1 except that the composite material was obtained by processing into pellets without kneading twice in the kneading process and that a hybrid injection molding machine (FNX140 available from Nissei Plastic Industrial Co., Ltd.; a mold clamping pressure of 140 tf, a screw diameter of 40, a full flight screw) was used to injection-mold the resulting composite material under conditions of a molding temperature of 220°C, a mold temperature of 50°C, an injection speed of 157 mm/s, an injection pressure of 111 MPa, and a holding pressure of 120 MPa into a size of 150 mm x 150 mm × 3 mm.

[Example 3]

An electromagnetic wave absorber was obtained in the same manner as in Example 1 except that the amount of carbon black was changed to 11% by volume.

[Comparative Example 1]

Using a thermoplastic resin (T-401 available from Toyobo Co., Ltd.) made of polyamide 6 blended with 20% by weight of glass fibers and using carbon black (TOKABLACK #5500 available from Tokai Carbon Co., Ltd.) as a conductive filler, amounts shown in TABLE 1 below were simultaneously fed using an external feeder through a feed port at 3 kg/h for polyamide 6 (containing 20% by weight of glass fibers) and at 0.66 kg/h for carbon black. Then, LABO PLASTOMILL (registered trademark) (100C100 available from Toyo Seiki Seisaku-sho, Ltd.) and the twin-screw segment extruder (2D30W2 available from Toyo Seiki Seisaku-sho, Ltd.) were used to melt and knead the polyamide 6 (containing 20% by weight of glass fibers) and the carbon black under conditions shown in TABLE 1 below. Extruded strands were processed into pellets, whereby an intended composite material was obtained.

The hybrid injection molding machine (FNX140 available from Nissei Plastic Industrial Co., Ltd.; a mold clamping pressure of 140 tf, a screw diameter of 40, a full flight screw) was used to injection-mold this composite material under conditions of a molding temperature of 260°C, a mold temperature of 81°C, an injection speed of 158 mm/s, an injection pressure of 57 MPa, and a holding pressure of 50 MPa into a size of 150 mm × 150 mm × 3 mm, thereby obtaining a plate-shaped electromagnetic wave absorber.

In this electromagnetic wave absorber, the carbon black is dispersed uniformly, and portions A and B with different carbon black content percentages are not present.

<Examples 1 to 3 and Comparative Example 1>

For the electromagnetic wave absorbers of Examples 1 to 3 and Comparative Example 1, transmission attenuation was measured using a vector network analyzer (available from Keysight Technologies) based on JIS R 1679 at a frequency of 70 to 90 GHz, with transmitting and receiving antennas placed in a straight line in face-to-face relationship with a plate-like test specimen plane. Return loss was measured based on JIS R 1679 except that a reference metal plate was not provided. Measured values are shown together in TABLE 2 below. In TABLE 2, the transmission attenuation and the return loss are shown in absolute values.

<Examples 1 to 3>

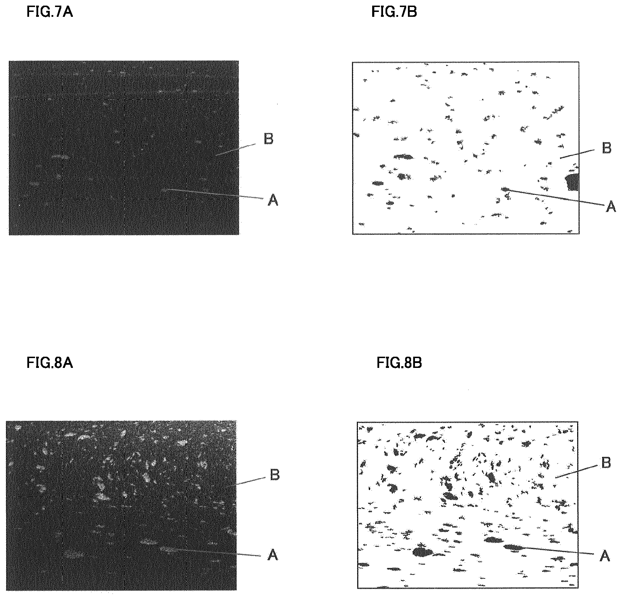

SEM images (with a magnification of 50 times) of the cross-sections of Examples 1 to 3 and images obtained by binarizing the SEM images in accordance with the previously described procedure were shown in FIGS. 7A and 7B, FIGS. 8A and 8B, and FIGS. 9A and 9B. Based on these images, the sum ($\mu m^2$) of the areas of islands of the portions A and the area percentage of the portions A (the area percentage of the portions A with respect to the total area; the area percentage of the portions A per unit area) were calculated, and the number of islands of the portions A found in the entire field of view of 960 pixels in height and 1280 pixels in width was counted. These values are shown together in TABLE 2. In Examples 1 to 3, the aforementioned SEM photographing is performed on three arbitrary locations, values are calculated and counted for each of the locations, and the average of the values is used.

<Example 1>

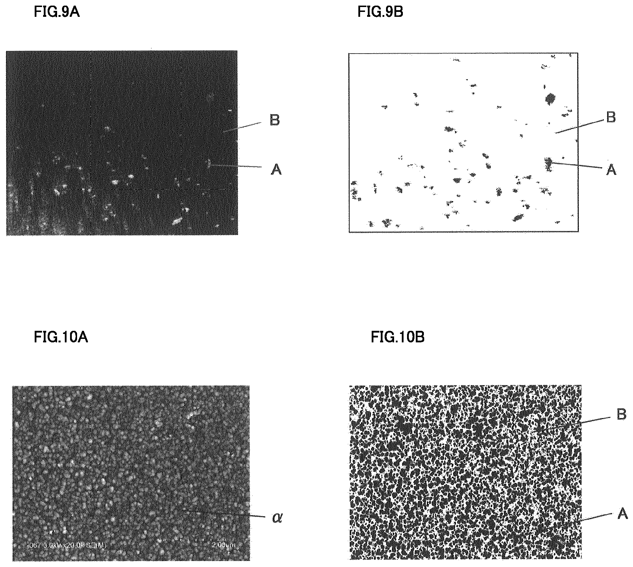

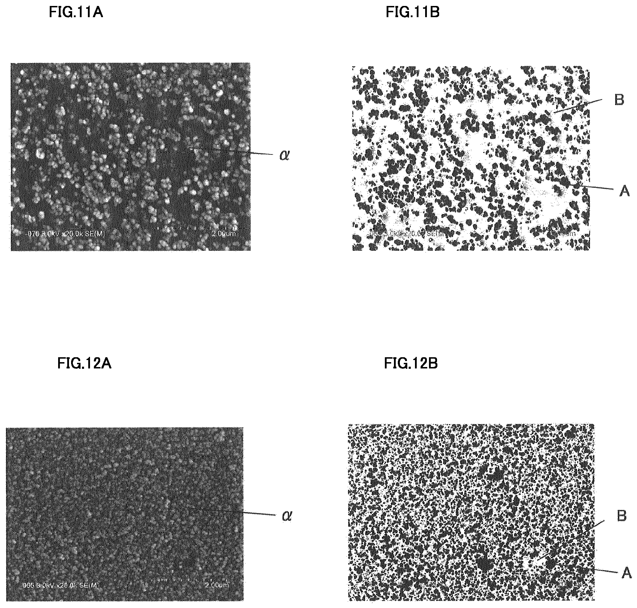

A SEM image (with a magnification of 20000 times) of a location recognized as a portion A in FIG. 7A which is observed at a higher magnification is shown in FIG. 10A, and an image obtained by binarizing this SEM image in accordance with the previously described procedure is shown in FIG. 10B. A SEM image (with a magnification of 20000 times) of a location recognized as a portion B in FIG. 7A which is observed at a higher magnification is shown in FIG. 11A, and an image obtained by binarizing this SEM image in accordance with the previously described procedure is shown in FIG. 11B.

Based on these images, the carbon black content percentages (% by area) in the respective portions A and B and the ratio therebetween (the carbon black content percentage in the portion A divided by the carbon black content percentage of the portion B) were calculated in accordance with the previously described procedure. These values are shown together in TABLE 1 below.

The aforementioned SEM photographing was performed on three arbitrary locations for each of the portions, values were calculated for each of the locations, and "the carbon black content percentage in the portion A divided by the carbon black content percentage in the portion B" was calculated in accordance with the aforementioned technique.

<Example 2>

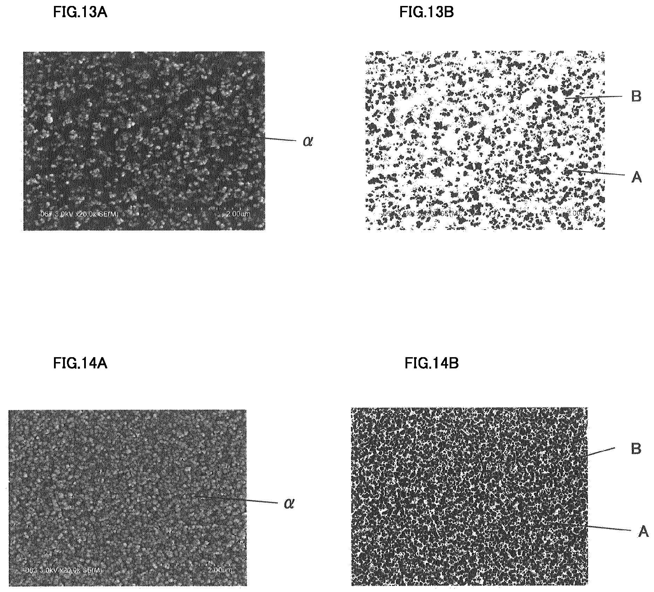

A SEM image (with a magnification of 20000 times) of a location recognized as a portion A in FIG. 8A which is observed at a higher magnification is shown in FIG. 12A, and an image obtained by binarizing this SEM image in accordance with the previously described procedure is shown in FIG. 12B. A SEM image (with a magnification of 20000 times) of a location recognized as a portion B in FIG. 8A which is observed at a higher magnification is shown in FIG. 13A, and an image obtained by binarizing this SEM image in accordance with the previously described procedure is shown in FIG. 13B.

Based on these images, the carbon black content percentages (% by area) in the respective portions A and B and the ratio therebetween (the carbon black content percentage in the portion A divided by the carbon black content percentage in the portion B) were calculated in accordance with the previously described procedure. These values are shown together in TABLE 1 below.

The aforementioned SEM photographing was performed on three arbitrary locations for each of the portions, values were calculated for each of the locations, and "the carbon black content percentage in the portion A divided by the carbon black content percentage in the portion B" was calculated in accordance with the aforementioned technique.

<Example 3>

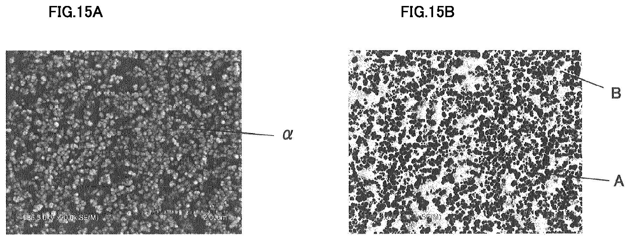

A SEM image (with a magnification of 20000 times) of a location recognized as a portion A in FIG. 9A which is observed at a higher magnification is shown in FIG. 14A, and an image obtained by binarizing this SEM image in accordance with the previously described procedure is shown in FIG. 14B. A SEM image (with a magnification of 20000 times) of a location recognized as a portion B in FIG. 9A which is observed at a higher magnification is shown in FIG. 15A, and an image obtained by binarizing this SEM image in accordance with the previously described procedure is shown in FIG. 15B.

Based on these images, the carbon black content percentages (% by area) in the respective portions A and B and the ratio therebetween (the carbon black content percentage in the portion A divided by the carbon black content percentage in the portion B) were calculated in accordance with the previously described procedure. These values are shown together in TABLE 1 below.

The aforementioned SEM photographing was performed on three arbitrary locations for each of the portions, values were calculated for each of the locations, and "the carbon black content percentage in the portion A divided by the carbon black content percentage in the portion B" was calculated in accordance with the aforementioned technique.

In Examples 1 and 3 which are formed by pressing, each test specimen is cut with a precision high-speed cutting machine vertically along a line that passes through the center of each test specimen as seen in plan view and that divides the area thereof in two, whereby a cross-section is provided. In Example 2 and Comparative Example 1 which are formed by injection molding, a flow direction is clearly recognizable. For this reason, each test specimen is cut with a precision high-speed cutting machine vertically near the middle of each test specimen as seen in the flow direction, whereby a cross-section is provided. Then, an ion milling device is used to polish and coat the cross-sections of the test specimens. Comparative Example 1, on the other hand, is not photographed with a SEM because the carbon black is dispersed uniformly.

[TABLE 1]

| | Type of thermoplastic resin | Carbon black content (% by volume) | Kneading method | Molding method | Carbon black content percentage in portion A (% by area) | Carbon black content percentage in portion B (% by area) | Ratio between carbon black content percentages (A/B) |
|---|---|---|---|---|---|---|---|
| Ex. 1 | Polypropylene | 7.8 | Continuous (twice) | Pressing | 54 | 33 | 1. 6 |
| Ex. 2 | Polypropylene | 7.8 | Continuous | Injection molding | 48 | 25 | 1.9 |
| Ex. 3 | Polypropylene | 11 | Continuous (twice) | Pressing | 67 | 51 | 1.3 |
| Comp. Ex. 1 | Polyamide 6 | 14 | Continuous | Injection molding | - | - | - |

[TABLE 2]

| | Portions A | | | | | Value β in Equation (1) | Transmission attenuation (dB) | Transmission attenuation (dB)/ carbon black content (% by volume) | Return loss (dB) |
|---|---|---|---|---|---|---|---|---|---|
| | Sum of areas of islands ($\mu$m$^2$) | Area percentage (%) | Maximum area ($\mu$m$^2$) | Minimum area ($\mu$m$^2$) | Number of islands | | | | |
| Ex. 1 | 125403 | 2.6 | 23311 | 4 | 152 | 7 . 1 | 20 | 2. 6 | 6 |
| Ex. 2 | 321708 | 6.7 | 20806 | 8 | 267 | 20.4 | 42 | 5.4 | 4 |
| Ex. 3 | 82506 | 1.7 | 8564 | 4 | 127 | 5. 6 | 72 | 6.5 | 4 |
| Comp. Ex. 1 | - | - | - | - | - | - | 9 | 0. 6 | 5 |

The results listed in TABLES 1 and 2 above show that Examples 1 to 3 are capable of exhibiting excellent electromagnetic wave absorption performance, and particularly excellent transmission attenuation. In the light of common technical practice, the electromagnetic wave absorption capacity of Comparative Example 1 which is high in carbon black content is superior. However, the electromagnetic wave absorber of the present disclosure has excellent electromagnetic wave absorption capacity with a low carbon black content, and particularly excellent transmission attenuation per carbon black content.

Although specific forms in the present disclosure have been described in the aforementioned examples, the aforementioned examples should be considered as merely illustrative and not restrictive. It is contemplated that various modifications evident to those skilled in the art could be made without departing from the scope of the present disclosure.

The composite material according to one aspect of the present disclosure, which is capable of exhibiting performance capability of absorbing unwanted electromagnetic waves over a long period of time, is preferably used for an electromagnetic wave absorber for a millimeter-wave radar for use in a vehicle collision avoidance system. The composite material may also be used for other purposes of suppressing radio wave interference and reducing noises in a next generation mobile communication system (5G) using millimeter waves and in the fields of home appliances and life sciences.

REFERENCE SIGNS LIST

A Portion with a high conductive filler content percentage
B Portion with a low conductive filler content percentage

**Claims**

1. A composite material comprising:

    a single type of thermoplastic resin; and
    a conductive filler contained in a dispersed state in the thermoplastic resin,
    wherein the composite material includes a portion A and a portion B each comprising a different content amount of the conductive filler in a mixed manner, and
    wherein a ratio of the content amount of conductive filler in the portion A to the content amount of conductive filler in the portion B is greater than 1.0.

2. The composite material according to claim 1,
    wherein an area ratio of the portion A per unit area of a cross-section of a molded article made by molding the composite material is 0.1 to 50%.

3. The composite material according to claim 1 or 2 comprising a plurality of the portions A recognized in the form of islands in a cross-section of a molded article made by molding the composite material,
    wherein the number of the portions A found in the entire field of view of 960 pixels in height and 1280 pixels in width is 5 to 2000 when the magnification of a scanning electron microscope is 50 times.

4. An electromagnetic wave absorber made by molding a composite material according to any one of claims 1 to 3.

FIG.1

A          B

FIG.2

A          B

FIG.3

FIG.4

FIG.5

A

FIG.6

B

FIG.7A

FIG.7B

FIG.8A

FIG.8B

FIG.9A

FIG.9B

FIG.10A

FIG.10B

FIG.11A

α

FIG.11B

B

A

FIG.12A

α

FIG.12B

B

A

FIG.13A

FIG.13B

FIG.14A

FIG.14B

FIG.15A

α

FIG.15B

B

A

## INTERNATIONAL SEARCH REPORT

| International application No. |
| --- |
| PCT/JP2021/000948 |

A. CLASSIFICATION OF SUBJECT MATTER
Int.Cl. C08L101/00(2006.01)i, H05K9/00(2006.01)i
FI: C08L101/00, H05K9/00M

According to International Patent Classification (IPC) or to both national classification and IPC

B. FIELDS SEARCHED

Minimum documentation searched (classification system followed by classification symbols)
Int.Cl. C08L101/00, H05K9/00

Documentation searched other than minimum documentation to the extent that such documents are included in the fields searched
    Published examined utility model applications of Japan    1922-1996
    Published unexamined utility model applications of Japan    1971-2021
    Registered utility model specifications of Japan    1996-2021
    Published registered utility model applications of Japan    1994-2021

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 2015-15373 A (KRI INC.) 22 January 2015 (2015-01-22), claims 1, 4, 7, 8, 11, paragraphs [0001], [0010], [0012], [0020] | 1-4 |
| X | JP 2017-141370 A (DENKA CO., LTD.) 17 August 2017 (2017-08-17), claims 1, 4, 5, 6, 8, paragraph [0115], examples 9-14 | 1-4 |
| X | WO 2016/021672 A1 (DENKA CO., LTD.) 11 February 2016 (2016-02-11), claims 1, 4, 5, paragraph [0130], examples 5-7, 13-20 | 1-4 |
| X | JP 2018-160688 A (SEKISUI CHEMICAL CO., LTD.) 11 October 2018 (2018-10-11), claims 1, 4, examples 1-5 | 1-4 |

☒ Further documents are listed in the continuation of Box C.    ☒ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| 04 March 2021 | 16 March 2021 |

| Name and mailing address of the ISA/ | Authorized officer |
| --- | --- |
| Japan Patent Office 3-4-3, Kasumigaseki, Chiyoda-ku, Tokyo 100-8915, Japan | Telephone No. |

Form PCT/ISA/210 (second sheet) (January 2015)

Form PCT/ISA/210 (second sheet) (January 2015)

**INTERNATIONAL SEARCH REPORT**

International application No.

PCT/JP2021/000948

C (Continuation).    DOCUMENTS CONSIDERED TO BE RELEVANT

| Category* | Citation of document, with indication, where appropriate, of the relevant passages | Relevant to claim No. |
|---|---|---|
| X | JP 2017-179315 A (FURUKAWA ELECTRIC CO., LTD.) 05 October 2017 (2017-10-05), paragraph [0086], comparative examples 2, 4 | 1-4 |
| X | WO 2019/088062 A1 (DAICEL POLYMER LTD.) 09 May 2019 (2019-05-09), claims 1, 2, examples | 1-4 |
| X | WO 2018/159483 A1 (MITSUI CHEMICALS, INC.) 07 September 2018 (2018-09-07), claims 1, 11, paragraphs [0063], [0064], examples | 1-4 |
| A | JP 2016-503117 A (LG CHEMICAL LTD.) 01 February 2016 (2016-02-01) | 1-4 |
| A | JP 2017-512847 A (LG CHEMICAL LTD.) 25 May 2017 (2017-05-25) | 1-4 |

**INTERNATIONAL SEARCH REPORT**
Information on patent family members

| International application No. |
|---|
| PCT/JP2021/000948 |

```
JP 2015-15373 A     22 January 2015      (Family: none)

JP 2017-141370 A    17 August 2017       (Family: none)

WO 2016/021672 A1   11 February 2016     US 2017/0365372 A1
                                         claims 1, 4, 5,
                                         paragraph [0177],
                                         examples 5-7, 13-20
                                         CN 106661333 A

JP 2018-160688 A    11 October 2018      US 2015/0337105 A1
                                         claims 1, 6, examples 1-5
                                         EP 2928277 A1
                                         CN 104541594 A
                                         KR 10-2015-0091461 A

JP 2017-179315 A    05 October 2017      (Family: none)

WO 2019/088062 A1   09 May 2019          CN 111279808 A

WO 2018/159483 A1   07 September 2018    US 2020/0010588 A1
                                         claims 1, 11, paragraphs [0124],
                                         [0127], examples
                                         EP 3591010 A1
                                         KR 10-2019-0104076 A
                                         CN 110325595 A

JP 2016-503117 A    01 February 2016     US 2016/0276055 A1
                                         EP 3079155 A1
                                         KR 10-2015-0066211 A
                                         CN 104919539 A

JP 2017-512847 A    25 May 2017          US 2017/0066907 A1
                                         EP 3187526 A1
                                         KR 10-2016-0026805 A
                                         CN 106164151 A
```

Form PCT/ISA/210 (patent family annex) (January 2015)

**REFERENCES CITED IN THE DESCRIPTION**

**Patent documents cited in the description**

- JP 2017179315 A